# EUROPEAN PATENT APPLICATION

(11) **EP 1 071 314 A1**
(43) Date of publication of application: **24.01.2001**
(21) Application number: 99926814.7
(22) Date of filing: 25.06.1999
(51) Int. Cl.: H05B 33/22, H05B 33/14

(54) **ORGANIC EL DEVICE**

(30) Priority: 10.02.1999 JP 3324499
(71) Applicant: TDK Corporation, Chuo-ku, Tokyo 103-8272 (JP)
(72) Inventor: ARAI, Michio TDK Corporation, Tokyo 103-8272 (JP); KOBORI, Isamu TDK Corporation, Tokyo 103-8272 (JP); MITSUHASHI, Etsuo TDK Corporation, Tokyo 103-8272 (JP)
(74) Representative: Wise, Stephen James
(86) International application number: JP9903396
(87) International publication number: WO0048430

(57) **Abstract**

An object of the present invention is to provide an organic EL device which has a performance equivalent or superior to conventional devices provided with a hole injecting and transporting layer and/or an electron injecting and transporting layer prepared from an organic substance; which has long life, sufficient weatherability, high stability, and high efficiency; which is inexpensive; and which can be readily produced even when the light emitting layer comprises two or more layers and the resulting film interface is provided with stable physical properties. In view of such object, the organic electroluminescent device comprises a substrate, a hole injecting electrode and an electron injecting electrode formed on the substrate, a light emitting layer containing an organic substance formed between the electrodes, and an inorganic insulative electron injecting and transporting layer formed between the light emitting layer and the electron injecting electrode. The inorganic insulative electron injecting and transporting layer contains lithium oxide as its main component and magnesium oxide as its stabilizer, and the lithium oxide calculated on the bases of Li₂O comprises 80 mol% or more of the entire components.

## Description

### BACKGROUND OF THE INVENTION

### Technical Field

This invention relates to an organic EL (electroluminescent) device, and more particularly, to an inorganic/organic junction structure suitable for use in a device of the type wherein an electric field is applied to a thin film of an organic compound to emit light.

### Background Art

In general, organic EL devices have a basic configuration including a glass substrate, a transparent electrode of ITO etc., a hole transporting layer of an organic amine compound, an organic light emitting layer of a material exhibiting electronic conductivity and intense light emission such as Alq3, and an electrode of a low work function metal such as MgAg, wherein the layers are stacked on the substrate in the described order.

The device configurations which have been reported thus far have one or more organic compound layers interposed between a hole injecting electrode and an electron injecting electrode. The organic compound layers are typically of two- or three-layer structure.

Included in the two-layer structure are a structure having a hole transporting layer and a light emitting layer formed between the hole injecting electrode and the electron injecting electrode and another structure having a light emitting layer and an electron transporting layer formed between the hole injecting electrode and the electron injecting electrode. Included in the three-layer structure is a structure having a hole transporting layer, a light emitting layer, and an electron transporting layer formed between the hole injecting electrode and the electron injecting electrode. Also known is a one-layer structure wherein a single layer playing all the roles is formed from a polymer or a mixed system.

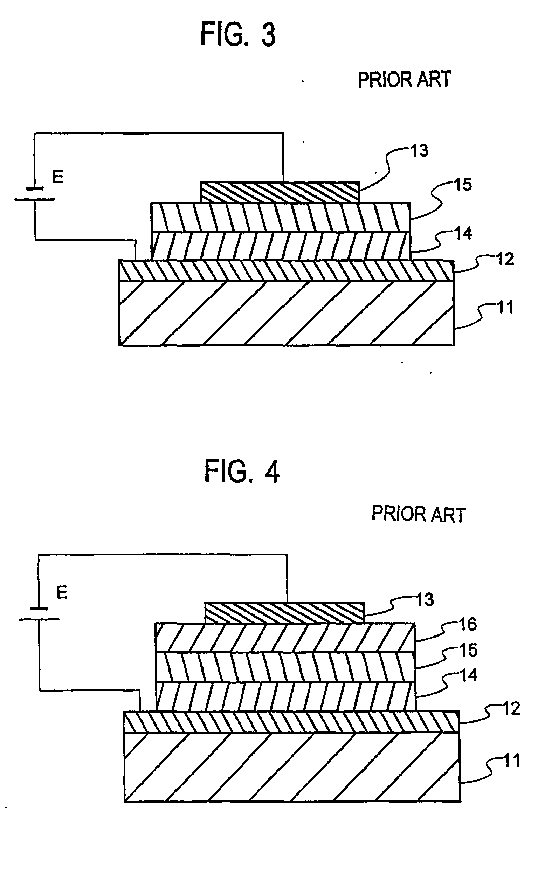

FIGS. 3 and 4 illustrate typical configurations of organic EL devices.

In FIG. 3, a hole transporting layer 14 and a light emitting layer 15 of organic compounds are formed between a hole injecting electrode 12 and an electron injecting electrode 13 on a substrate 11. In this configuration, the light emitting layer 15 also serves as an electron transporting layer.

In FIG. 4, a hole transporting layer 14, a light emitting layer 15, and an electron transporting layer 16 of organic compounds are formed between a hole injecting electrode 12 and an electron injecting electrode 13 on a substrate 11.

The organic electroluminescent devices of the types as described above all suffer from insufficient reliability. More illustratively, organic electroluminescent devices should be provided with a hole injecting electrode, an electron injecting electrode and an organic layer which enables efficient injection and transportation of the holes/electrons between the electrodes in view of their design principles, and the materials used for the organic layer are likely to suffer from damages in the course of the device production as well as insufficient affinity for the electrodes. Such materials also require use of a metal of low work function for the electron injecting electrode provided for the purpose of electron injection, and therefore, use of a material such as MgAg or AlLi suffering from low oxidation resistance and low stability. Use of such material has often been a determinant for the life of the organic electroluminescent devices, and a major factor for the reduced reliability. The organic thin film also suffered from deterioration at a rate much faster than that of LED (light emitting diodes) and LD (laser diodes).

In addition, many of the organic materials are expensive, and there is a considerable merit in substituting some of the films with less expensive inorganic materials to thereby provide a product employing the organic electroluminescent device at a reduced cost.

There is also a demand for development of an organic electroluminescent devices capable of providing a higher efficiency at a lower drive voltage and at a reduced current consumption.

In order to solve the problems as described above, attempts have been made to simultaneously utilize the benefits of an organic material and an inorganic semiconductor material, namely, by producing an organic/inorganic semiconductor junction wherein an organic hole transporting layer is replaced with an inorganic p-type semiconductor. Such attempts are disclosed in USP 2636341, Japanese Patent Application Laid-Open Nos. (JP-A) 139893/1990, 207488/1990, and 119973/1994. The organic electroluminescent devices disclosed therein were still inferior in their light emitting properties and reliability of the basic device compared to conventional organic electroluminescent devices.

In view of the situation as described above, the inventors of the present invention proposed in Japanese Patent Application No. 303350/1998 an inorganic insulative electron injecting and transporting layer which comprises at least one oxide selected from lithium oxide, rubidium oxide, potassium oxide, sodium oxide, and cesium oxide as a first component, at least one oxide selected from strontium oxide, magnesium oxide, and calcium oxide as a second component, and silicon oxide and/or germanium oxide as a third component.

The organic electroluminescent device having such inorganic insulative electron injecting and transporting layer still suffered from insufficient electron injecting capability, difficulty in the production of the target used in the film deposition by sputtering, and various other problems.

### SUMMARY OF THE INVENTION

An object of the present invention is to realize an organic electroluminescent device which has a performance equivalent or superior to the conventional device which has an electron injecting and transporting layer prepared from an organic substance; which has an electron injecting efficiency higher than the conventional inorganic device; which has long life, sufficient weatherability and high stability; and which is inexpensive.

Another object of the present invention is to realize a readily producible organic electroluminescent device which can be produced from stable materials using readily producible targets.

This and other objects are achieved by the present invention which is defined below.
(1) An organic electroluminescent device comprising a substrate, a hole injecting electrode and an electron injecting electrode formed on the substrate, and a light emitting layer containing an organic substance formed between the electrodes; wherein
   an inorganic insulative electron injecting and transporting layer is formed between the light emitting layer and the electron injecting electrode;
   said inorganic insulative electron injecting and transporting layer contains lithium oxide as its main component and magnesium oxide as its stabilizer; and
   said lithium oxide calculated on the bases of Li₂O comprises 80 mol% or more of the entire components.
(2) An organic electroluminescent device according to the above (1) wherein said inorganic insulative electron injecting and transporting layer has a film thickness of 0.1 to 2 nm.

### BRIEF DESCRIPTION OF THE DRAWINGS

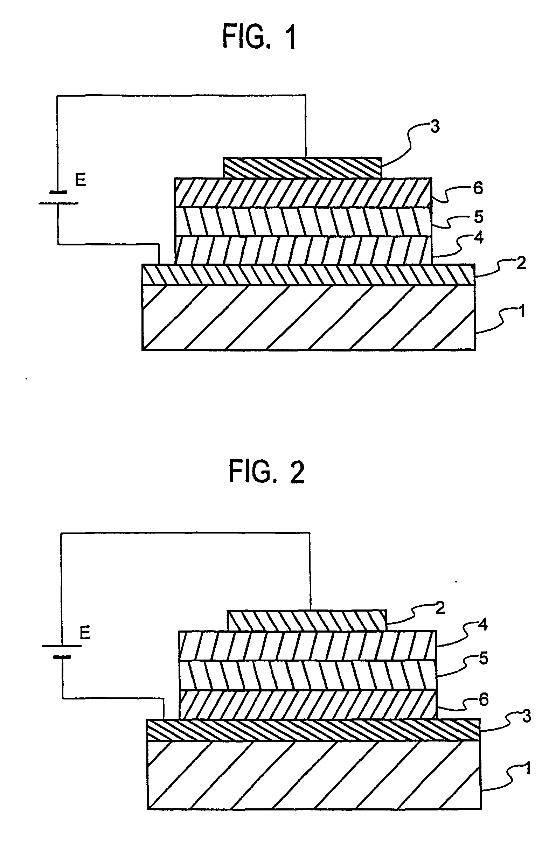

FIG. 1 is a schematic cross-sectional view illustrating an organic EL device according to an embodiment of the invention.
FIG. 2 is a schematic cross-sectional view illustrating an organic EL device according to another embodiment of the invention.
FIG. 3 is a schematic cross-sectional view illustrating a conventional organic EL device.
FIG. 4 is a schematic cross-sectional view illustrating another conventional organic EL device.

### DESCRIPTION OF PREFERRED EMBODIMENTS

The organic electroluminescent device of the present invention comprises a substrate, a hole injecting electrode and an electron injecting electrode formed on the substrate, and a light emitting layer containing an organic substance formed between the electrodes, and an inorganic insulative electron injecting and transporting layer is formed between the light emitting layer and the electron injecting electrode. The inorganic insulative electron injecting and transporting layer contains lithium oxide as its main component and magnesium oxide as its stabilizer. The lithium oxide calculated on the bases of Li₂O comprises 80 mol% or more of the entire components.

By constituting the inorganic insulative electron injecting and transporting layer using lithium oxide for the main component and magnesium oxide for the stabilizer, drastic improvement in the electron injecting efficiency of the inorganic insulative electron injecting and transporting layer can be realized. Also, there is no longer any need to specifically form an electrode which has electron injecting function. As a consequence, a metal electrode which has a relatively high stability as well as good electric conductivity can be employed, and the device is thereby provided with a prolonged life.

The inorganic insulative electron injecting and transporting layer contains at least 80 mol%, preferably 80 to 98 mol%, and most preferably 90 to 98 mol% based on total components of lithium oxide (Li₂O) as its main component. Content of the main component in excess of such range results in markedly reduced electron injecting function.

The inorganic insulative electron injecting and transporting layer contains residual content (the content excluding the main component) of magnesium oxide (MgO) as the stabilizer. Accordingly, the content of magnesium oxide is up to 20 mol%, preferably 2 to 20 mol%, and most preferably 2 to 10 mol% of the total components. Content of the stabilizer below such range results in reduced stability of the inorganic insulative electron injecting and transporting thin film and the target.

The magnesium oxide used for the stabilizer has a large band gap as well as a low work function, and therefore, stability can be improved without detracting from the high electron injecting capability of the lithium oxide. Magnesium oxide is also capable of improving sintering degree of the target. Swelling of the target by water absorption when left in air is thereby suppressed. As a consequence, production and handling convenience of the target is improved, and the production process of the organic electroluminescent device can be simplified.

These oxides are generally present in stoichiometric composition, but may deviate more or less therefrom and take non-stoichiometric compositions.

The inorganic insulative electron injecting and transporting layer preferably has a thickness of 0.1 to 2 nm, and more preferably 0.3 to 0.8 nm.

The inorganic insulative electron injecting and transporting layer may be produced by any of various physical and chemical thin film forming processes including sputtering and EB evaporation, among which the sputtering being the preferred.

When the inorganic insulative electron injecting and transporting layer is formed by sputtering, the sputtering gas is preferably under a pressure of 0.1 to 1 Pa during sputtering. The sputtering gas may be any of inert gases used in conventional sputtering equipment, for example, Ar, Ne, Xe, and Kr. Reactive sputtering may be carried out in an atmosphere of the sputtering gas mixed with about 1 to about 99% of oxygen (O₂) gas. The target may be the oxide as described above, and the sputtering may be either single target sputtering or multi-target sputtering.

The sputtering process may be an RF sputtering process using an RF power source or a DC reactive sputtering process, with the RF sputtering being especially preferred. The power of the sputtering equipment is preferably in the range of 0.1 to 10 W/cm² for RF sputtering. The deposition rate is preferably in the range of 0.5 to 10 nm/min., especially 1 to 5 nm/min. The substrate temperature during the deposition may be in the range of room temperature (about 25°C) to about 150°C.

The sputtering process may be a reactive sputtering process using a reactive gas. Exemplary reactive gases include N₂, NH₃, NO, NO₂, N₂O and the like when nitrogen is to be incorporated, and CH₄, C₂H₂, CO and the like when carbon is to be incorporated. These reactive gases may be used either alone or in combination of two or more.

It is noted that when the inorganic insulative electron injecting and transporting layer is deposited, the organic layer or the like may experience ashing, and hence, damaging. Under such conditions, it is recommended that the inorganic insulative electron injecting and transporting layer is deposited in two layers. That is, the layer is initially thinly deposited in the absence of oxygen and then thickly deposited in the presence of oxygen. The thickness reached in the absence of oxygen is preferably about 1/5 to about 4/5 of the overall thickness. The oxygen poor layer which is deposited in the absence of oxygen is preferably adjusted to about 60 to 90% of the normal oxygen content. The oxidized layer which is deposited in the presence of oxygen is available in the stoichiometric composition of normal oxide although it may deviate somewhat from the stoichiometry. Accordingly, the difference of oxygen content between the oxygen poor layer arid the oxidized layer is preferably at least 10%, especially at least 20%. Also, the oxygen content may continuously vary within the above-defined range.

The temperature of the substrate during the deposition is from room temperature (25°C) to about 150°C.

Adjacent to the inorganic insulative electron injecting and transporting layer (on the side opposite to the light emitting layer) is formed a negative electrode. The negative electrode combined with the inorganic insulative electron injecting and transporting layer as described below does not necessary have electron injecting capability at low work function, and therefore, is not limited to any particular type. However, use or one or two metal elements selected from Al, Ag, In, Ti, Cu, Au, Mo, W, Pt, Pd and Ni, and in particular, from Al and Ag is preferable in view of the electric conductivity and handling convenience.

Such negative electrode thin film may have at least a sufficient thickness to supply the inorganic insulative electron injecting and transporting layer with electrons, for example, a thickness of at least 50 nm, and preferably at least 100 nm. Although no particular upper limit is set for the film thickness, the film thickness may be generally in the range of about 50 to about 500 nm.

The negative electrode used in the organic EL device of the present invention in combination with the inorganic insulative electron injecting and transporting layer as described below may preferably comprise the metal elements as described above. If desired, the negative electrode may alternatively comprise a simple metal element for example, K, Li, Na, Mg, La, Ce, Ca, Sr, Ba, Sn, Zn, or Zr, or a binary or ternary alloy containing such metal element for stability improvement. Exemplary alloys are Ag-Mg (Ag: 0.1 to 50 at%), Al-Li (Li: 0.01 to 14 at%), In-Mg (Mg: 50 to 80 at%), and Al-Ca (Ca: 0.01 to 20 at%).

Such electron injecting electrode thin film may have at least a sufficient thickness to effect electron injection, for example, a thickness of at least 0.1 nm, preferably at least 0.5 nm, and more preferably at least 1 nm. Although the upper limit is not critical, the electrode thickness is typically about 1 to about 500 nm. On the electron injecting electrode, an auxiliary electrode (protective electrode) may be provided, if desired.

The auxiliary electrode may have at least a sufficient thickness to ensure efficient electron injection and prevent the ingress of moisture, oxygen and organic solvents, for example, a thickness of at least 50 nm, preferably at least 100 nm, more preferably 100 to 500 nm. A too thin auxiliary electrode layer would exert its effect little, lose a step coverage capability, and provide insufficient connection to a terminal electrode. If too thick, greater stresses are generated in the auxiliary electrode layer, accelerating the growth rate of dark spots.

For the auxiliary electrode, an appropriate material may be chosen in consideration of the material of the electron injecting electrode to be combined therewith. For example, low resistivity metals such as aluminum may be used when electron injection efficiency is of importance. Metal compounds such as TiN may be used when sealing is of importance.

The thickness of the electron injecting electrode and the auxiliary electrode combined is usually about 50 to about 500 nm though it is not critical.

For the hole injecting electrode, preferred are materials capable of effectively injecting holes into the hole injecting layer having a work function of 4.5 to 5.5 ev. Useful are compositions based on tin-doped indium oxide (ITO), zinc-doped indium oxide (IZO), indium oxide (In₂O₃), tin oxide (SnO₂) or zinc oxide (ZnO). These oxides may deviate more or less from their stoichiometric compositions. For ITO, an appropriate proportion of SnO₂ mixed with In₂O₃ is about 1 to 20%, more preferably about 5 to 12% by weight. For IZO, an appropriate proportion of ZnO mixed with In₂O₃ is about 12 to 32% by weight.

The hole injecting electrode may further contain silicon oxide (SiO₂) for the purpose of adjusting the work function. The content of silicon oxide (SiO₂) is preferably about 0.5 to 10% as expressed in mol percent of SiO₂ based on ITO. Inclusion of SiO₂ results in an increased work function in ITO.

The electrode on the light exit side should preferably have a light transmittance of at least 50%, more preferably at least 60%, and most preferably at least 70% in the light emission band, typically from 400 to 700 nm, and especially at each light emission. With a lower transmittance, the light emitted by the light emitting layer is attenuated through the electrode, failing to provide a luminance necessary as a light emitting device.

Preferably the electrode has a thickness of 50 to 500 rim, especially 50 to 300 nm. Although the upper limit of the electrode thickness is not critical, a too thick electrode would cause a drop of transmittance and separation. Too thin an electrode is insufficient for its effect and low in film strength during fabrication.

As shown in FIG. 1, for example, the organic electroluminescent device of the present invention may have a successively stacked configuration of a substrate 1/ hole injecting electrode 2/ hole injecting and transporting layer 4/ light emitting layer 5/ inorganic insulative electron injecting and transporting layer 6/ negative electrode 3. As shown in FIG. 2, for example, the organic electroluminescent device of the present invention may also have a reversely stacked configuration of substrate 1/ negative electrode 3/ inorganic insulative electron injecting and transporting layer 6/ light emitting layer 5/ hole injecting and transporting layer 4/ hole injecting electrode 2. In FIGS. 1 and 2, a drive supply E is connected between the hole injecting electrode 2 and the negative electrode 3.

The stacked configuration as described above may be used in practice by selecting optimal configuration and/or by making necessary changes in accordance with the performance required for and the application of the particular device.

The light emitting layer comprises stacked thin layers of one or more organic compounds which are involved in the light emitting function.

The light emitting layer has the function of injecting the holes (positive holes) and the electrons, the function of transporting such holes and electrons, and the function of producing exciter by recombination of the holes and the electrons. By using a relatively neutral compound for the light emitting layer, the electrons and the holes can be readily injected and transported at a good balance.

The light emitting layer may optionally include hole injecting and transporting layer, the electron injecting and transporting layer, and the like in addition to the light emitting layer in the narrow sense.

The hole injecting and transporting layer has the functions of facilitating injection of holes from the hole injecting electrode, transporting holes stably, and obstructing electrons. The optionally provided electron transporting layer has the function of facilitating injection of electrons from the inorganic insulative electron injecting and transporting layer, transporting electrons stably, and obstructing holes. These layers are effective for increasing the number of holes and electrons injected into the light emitting layer and confining holes and electrons therein for optimizing the recombination region to improve luminous efficiency. It should be noted that an organic electron transporting layer is generally not provided.

The thickness of the light emitting layer, the thickness of the hole injecting and transporting layer, and the thickness of the electron transporting layer are not critical, and may vary with the particular formation technique although the thickness is usually preferred to range from about 5 nm to about 500 nm, especially about 10 nm to about 300 nm.

The thickness of the organic hole injecting and transporting layer and the thickness of the electron transporting layer are substantially equal to or in the range of from about 1/10 times to about 10 times the thickness of the light emitting layer although the thickness may depend on the design of a recombination/light emitting region. When the hole injecting layer and the hole transporting layer is separately provided, preferably the injecting layer is at least 1 nm thick and the transporting layer is at least 1 nm thick. The upper limit of thickness is usually about 500 nm for the injecting layer and about 500 nm for the transporting layer. The same film thickness applies when two injecting/transporting layers are provided.

The light emitting layer of the organic EL device contains a fluorescent material that is a compound having a light emitting function. The fluorescent material may be at least one member selected from compounds as disclosed, for example, in JP-A 264692/1988, such as quinacridone, rubrene, and styryl dyes. Also, quinoline derivatives such as metal complex dyes having 8-quinolinol or a derivative thereof as the ligand such as tris(8-quinolinolato) aluminum are included as well as tetraphenylbutadiene, anthracene, perylene, coronene, and 12-phthaloperinone derivatives. Further useful are the phenylanthracene derivatives described in JP-A 12600/1996 (Japanese Patent Application No. 110569/1994) and the tetraarylethene derivatives described in JP-A 12969/1996 (Japanese Patent Application No. 114456/1994)

It is preferred to use such a compound in combination with a host material capable of light emission by itself, that is, to use the compound as a dopant. In this embodiment, the content of the compound in the light emitting layer is preferably 0.01 to 10 wt%, especially 0.1 to 5 wt%. In case of rubrene type dopant, the content is preferably 0.01 to 20 wt%. By using the compound in combination with the host material, the light emission wavelength of the host material can be altered, allowing light emission to be shifted to a longer wavelength and improving the luminous efficiency and stability of the device.

As the host material, quinolinolato complexes are preferable, with aluminum complexes having 8-quinolinol or a derivative thereof as the ligand being more preferable. These aluminum complexes are disclosed in JP-A 264692/1988, 255190/1991; 70733/1993, 258859/1993 and 215874/1994.

Illustrative examples include tris(8-quinolinolato) aluminum, bis(8-quinolinolato)magnesium, bis(benzo{f}-8-quinolinolato) zinc, bis(2-methyl-8-quinolinolato) aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolatoaluminum, tris(5,7-dibromo-8-hydroxyquinolinolato) aluminum, and poly [zinc(II)-bis(8-hydroxy-5-quinolinyl)methane].

Also useful are aluminum complexes having another ligand in addition to 8-quinolinol or a derivative thereof. Examples include bis(2-methyl-8-quinolinolato)(phenolato)aluminum(III), bis(2-methyl-8-quinolinolato)(ortho-cresolato)aluminum(III), bis(2-methyl-8-quinolinolato)(meta-cresolato)aluminum(III), bis(2-methyl-8-quinolinolato)(para-cresolato)aluminum(III), bis(2-methyl-8-quinolinolato)(ortho-phenylphenolato)aluminum(III), bis(2-methyl-8-quinolinolato)(meta-phenylphenolato)aluminum(III), bis(2-methyl-8-quinolinolato)(paraphenylphenolato)aluminum(III), bis(2-methyl-8-quinolinolato)(2,3-dimethylphenolato)aluminum(III), bis(2-methyl-8-quinolinolato)(2,6-dimethylphenolato)aluminum(III), bis(2-methyl-8-quinolinolato)(3,4-dimethylphenolato)aluminum(III), bis(2-methyl-8-quinolinolato)(3,5-dimethylphenolato)aluminum(III), bis(2-methyl-8-quinolinolato)(3,5-di-tert-butylphenolato)aluminum(III), bis(2-methyl-8-quinolinolato)(2,6-diphenylphenolato)aluminum(III), bis(2-methyl-8-quinolinolato)(2,4,6-triphenylphenolato)aluminum(III), bis(2-methyl-8-quinolinolato)(2,3,6-trimethylphenolato) aluminum(III), bis(2-methyl-8-quinolinolato)(2,3,5,6-tetramethylphenolato)aluminum(III), bis(2-methyl-8-quinolinolato)(1-naphtholato)aluminum(III), bis(2-methyl-8-quinolinolato)(2-naphtholato)aluminum(III), bis(2,4-dimethyl-8-quinolinolato)(orthophenylphenolato)aluminum(III), bis(2,4-dimethyl-8-quinolinolato)(para-phenylphenolato)aluminum(III), bis(2,4-dimethyl-8-quinolinolato)(meta-phenylphenolato)aluminum(III), bis(2,4-dimethyl-8-quinolinolato)(3,5-dimethylphenolato)aluminum(III), bis(2,4-dimethyl-8-quinolinolato)(3,5-di-tert-butylphenolato)aluminum(III), bis(2-methyl-4-ethyl-8-quinolinolato)(paracresolato) aluminum(III), bis(2-methyl-4-methoxy-8-quinolinolato)(para-phenylphenolato)aluminum(III), bis(2-methyl-5-cyano-8-quinolinolato)(orthocresolato) aluminum(III), and bis(2-methyl-6-trifluoromethyl-8-quinolinolato)(2-naphtholato)aluminum(III).

Also acceptable are bis(2-methyl-8-quinolinolato)aluminum(III)-µ-oxo-bis(2-methyl-8-quinolinolato)aluminum (III), bis(2,4-dimethyl-8-quinolinolato) aluminum(III)-µ-oxo-bis(2,4-dimethyl-8-quinolinolato)aluminum(III), bis(4-ethyl-2-methyl-8-quinolinolato) aluminum(III)-µ-oxo-bis(4-ethyl-2-methyl-8-quinolinolato) aluminum(III), bis(2-methyl-4-methoxyquinolinolato) aluminum(III)-µ-oxo-bis(2-methyl-4-methoxyquinolinolato) aluminum(III), bis(5-cyano-2-methyl-8-quinolinolato) aluminum(III)-µ-oxo-bis(5-cyano-2-methyl-8-quinolinolato) aluminum(III), and bis(2-methyl-5-trifluoromethyl-8-quinolinolato) aluminum(III)-µ-oxo-bis(2-methyl-5-trifluoromethyl-8-quinolinolato) aluminum(III).

Other useful host materials are the phenylanthracene derivatives described in JP-A 12600/1996 (Japanese Patent Application No. 110569/1994) and the tetraarylethene derivatives described in JP-A 12969/1996 (Japanese Patent Application No. 114456/1994).

The light emitting layer may also serve as the electron transporting layer. In this case, tris(8-quinolinolato) aluminum etc. are preferably used. These fluorescent materials may be evaporated.

Also, if necessary, the light emitting layer may also be a layer of a mixture of at least one hole injecting and transporting compound and at least one electron injecting and transporting compound, in which a dopant is preferably contained. In such a mix layer, the content of the compound is preferably 0.01 to 20 vol%, especially 0.1 to 15 vol%.

In the mix layer, carrier hopping conduction paths are created, allowing carriers to move through a polarly predominant material while injection of carriers of opposite polarity is rather inhibited, and the organic compound becomes less susceptible to damage, resulting in the advantage of an extended device life. By incorporating the aforementioned dopant in such a mix layer, the light emission wavelength the mix layer itself possesses can be altered, allowing light emission to be shifted to a longer wavelength and improving the luminous intensity and stability of the device.

The hole injecting and transporting compound and electron injecting and transporting compound used in the mix layer may be selected from the hole injecting and transporting compounds and the electron injecting and transporting compounds to be described later, respectively. Inter alia, the hole injecting and transporting compound is preferably selected from amine derivatives having strong fluorescence, for example, triphenyldiamine derivatives which are hole transporting materials, styrylamine derivatives and amine derivatives having an aromatic fused ring.

The electron injecting and transporting compound is preferably selected from quinoline derivatives and metal complexes having 8-quinolinol or a derivative thereof as a ligand, especially tris(8-quinolinolato) aluminum (Alq3). The aforementioned phenylanthracene derivatives and tetraarylethene derivatives are also preferable.

As the hole injecting and transporting compound, amine derivatives having intense fluorescence are useful, for example, the triphenyldiamine derivatives, styrylamine derivatives, and amine derivatives having an aromatic fused ring, exemplified above as the hole injecting and transporting material.

The mix ratio is preferably determined in accordance with the carrier density and carrier mobility of the respective compounds. It is usually preferred that the weight ratio of the hole injecting and transporting compound to the electron injecting and transporting compound range from about 1/99 to about 99/1, more preferably from about 10/90 to about 90/10, especially from about 20/80 to about 80/20.

Also preferably, the thickness of the mix layer ranges from the thickness of a mono-molecular layer to less than the thickness of the organic compound layer. Specifically, the mix layer is preferably 10 to 150 nm, and more preferably 50 to 100 nm.

Preferably the mix layer is formed by a co-deposition process of evaporating the compounds from distinct sources. If both the compounds have approximately equal or very close vapor pressures (evaporation temperatures), they may be pre-mixed in a common evaporation boat, from which they are evaporated together. The mix layer is preferably a uniform mixture of both the compounds although the compounds can be present in island form. The light emitting layer is generally formed to a predetermined thickness by evaporating an organic fluorescent material or coating a dispersion thereof in a resin binder.

As the hole injecting and transporting compound, use may be made of various organic compounds as described, for example, in JP-A 295695/1988, 191694/1990, 792/1991, 234681/1993, 239455/1993, 299174/1993, 126225/1995, 126226/1995, and 100172/1996, and EP 0650955A1. Exemplary are tetraarylbenzidine compounds (triaryldiamines or triphenyldiamines: TPD), aromatic tertiary amines, hydrazone derivatives, carbazole derivatives, triazole derivatives, imidazole derivatives, oxadiazole derivatives having an amino group, and polythiophenes. These compounds may be used alone or in admixture of two or more. On combined use of two or more of these compounds, they may be formed as separate stacked layers or mixed.

For the optional electron transporting layer, there may be used quinoline derivatives including organic metal complexes having 8-quinolinol or a derivative thereof as a ligand such as tris(8-quinolinolato) aluminum (Alq3), oxadiazole derivatives, perylene derivatives, pyridine derivatives, pyrimidine derivatives, quinoxaline derivatives, diphenylquinone derivatives, and nitro-substituted fluorene derivatives. The electron transporting layer can also serve as the light emitting layer. In this case, use of tris(8-quinolinolato) aluminum etc. is preferred. Like the light emitting layer, the electron transporting layer may be formed by evaporation or the like. Although the electron transporting layer comprising an organic material is generally unnecessary, such layer may be provided depending on the structure of the device and other conditions.

In forming the hole injecting and transporting layer, the light emitting layer, and the electron transporting layer comprising an organic material, vacuum evaporation is preferably used because homogeneous thin films are available. By utilizing vacuum evaporation, there is obtained a homogeneous thin film which is amorphous or has a crystal grain size of up to 0.2 µm. If the grain size is in excess of 0.2 µm, uneven light emission would take place and the drive voltage of the device must be increased with a substantial drop of hole injection efficiency.

The conditions for vacuum evaporation are not critical although a vacuum of 10⁻⁴ Pa or lower and a deposition rate of about 0.01 to 1 nm/sec. are preferred. It is preferred to successively form layers in vacuum because the successive formation in vacuum can avoid adsorption of impurities on the interface between the layers, thus ensuring better performance. Also, the drive voltage of a device can be reduced and the development and growth of dark spots be restrained.

In the embodiment wherein the respective layers are formed by vacuum evaporation, where it is desired for a single layer to contain two or more compounds, it is preferable that the boats having the compounds received therein are individually temperature controlled to achieve co-deposition.

Further preferably, a shield plate may be provided on the device in order to prevent the organic layers and electrodes from oxidation. In order to prevent the ingress of moisture, the shield plate is attached to the substrate through an adhesive resin layer for sealing. The sealing gas is preferably an inert gas such as argon, helium, and nitrogen. The sealing gas should preferably have a moisture content of less than 100 ppm, more preferably less than 10 ppm, especially less than 1 ppm. The lower limit of the moisture content is usually about 0.1 ppm though not critical.

The shield plate is selected from plates of transparent or translucent materials such as glass, quartz and resins, with glass being especially preferred. Alkali glass is preferred because of economy although other glass compositions such as soda lime glass, lead alkali glass, borosilicate glass, aluminosilicate glass, and silica glass are also useful. Of these, plates of soda glass without surface treatment are inexpensive and useful. Beside the glass plates, metal plates and plastic plates may also be used as the shield plate.

Using a spacer for height adjustment, the shield plate may be held at a desired height over the layer structure. The spacer may be formed from resin beads, silica beads, glass beads, and glass fibers, with the glass beads being especially preferred. Usually the spacer is formed from particles having a narrow particle size distribution while the shape of particles is not critical. Particles of any shape which does not obstruct the spacer function may be used. Preferred particles have an equivalent circle diameter of about 1 to 20 µm, more preferably about 1 to 10 µm, most preferably about 2 to 8 µm. Particles of such diameter should preferably have a length of less than about 100 µm. The lower limit of length is not critical although it is usually equal to or more than the diameter.

When a shield plate having a recess is used, the spacer may be used or not. When used, the spacer should preferably have a diameter in the above-described range, especially 2 to 8 µm.

The spacer may be premixed in a sealing adhesive or mixed with a sealing adhesive at the time of bonding. The content of the spacer in the sealing adhesive is preferably 0.01 to 30 wt%, more preferably 0.1 to 5 wt%.

Any of adhesives which can maintain stable bond strength and gas tightness may be used although UV curable epoxy resin adhesives of cation curing type are preferred.

In the organic EL structure of the invention, the substrate may be selected from amorphous substrates of glass and quartz and crystalline substrates of Si, GaAs, ZnSe, ZnS, GaP, and InP, for example. If desired, buffer layers of crystalline materials, amorphous materials or metals may be formed on such crystalline substrates. Metal substrates including Mo, Al, Pt, Ir, Au and Pd are also useful, Of these, glass substrates are preferred. Since the substrate is often situated on the light exit side, the substrate should preferably have a light transmittance as described above for the electrode.

A plurality of inventive devices may be arrayed on a plane. A color display is obtained when the respective devices of a planar array differ in emission color.

The substrate may be provided with a color filter film, a fluorescent material-containing color conversion film or a dielectric reflecting film for controlling the color of light emission.

The color filter film used herein may be a color filter as used in liquid crystal displays and the like. The properties of a color filter may be adjusted in accordance with the light emission of the organic EL device so as to optimize the extraction efficiency and color purity.

It is also preferred to use a color filter capable of cutting external light of short wavelength which is otherwise absorbed by the EL device materials and fluorescence conversion layer, because the light resistance and display contrast of the device are improved.

An optical thin film such as a multilayer dielectric film may be used instead of the color filter.

The fluorescence conversion filter film is to convert the color of light emission by absorbing electroluminescence and allowing the fluorescent material in the film to emit light. It is formed from three components: a binder, a fluorescent material, and a light absorbing material.

The fluorescent material used may basically have a high fluorescent quantum yield and desirably exhibits strong absorption in the electroluminescent wavelength region. In practice, laser dyes are appropriate. Use may be made of rhodamine compounds, perylene compounds, cyanine compounds, phthalocyanine compounds (including sub-phthalocyanines), naphthalimide compounds, fused ring hydrocarbon compounds, fused heterocyclic compounds, styryl compounds, and coumarin compounds.

The binder is selected from materials which do not cause extinction of fluorescence, preferably those materials which can be finely patterned by photolithography or printing technique. Also, where the filter film is formed on the substrate so as to be contiguous to the hole injecting electrode, those materials which are not damaged during deposition of the hole injecting electrode (such as ITO or IZO) are preferable.

The light absorbing material is used when the light absorption of the fluorescent material is short and may be omitted if unnecessary. The light absorbing material may also be selected from materials which do not cause extinction of fluorescence of the fluorescent material.

The organic EL device of the invention is generally of the dc or pulse drive type. The applied voltage is generally about 2 to 30 volts.

### EXAMPLES

Examples of the invention are given below by way of illustration to further describe the present invention.

### 〈Example 1〉

A glass substrate (manufactured by Corning Glass Works under the designation of 7059) was scrubbed using a neutral detergent. Next, the substrate was secured by a holder in a sputtering apparatus, and by DC magnetron sputtering from a target of ITO oxide, a hole injecting electrode layer of ITO was formed on the substrate.

The ITO electrode-bearing substrate was subjected to ultrasonic washing with neutral detergent, acetone, and ethanol, pulled up from boiling ethanol, dried, surface cleaned with UV/O₃, and then secured by a holder in a vacuum evaporation chamber, which was evacuated to a vacuum of 1x10⁻⁴ Pa or lower.

Next, polythiophene was evaporated at a deposition rate of 0.1 nm/sec. to a thickness of 10 nm to form a hole injecting layer, and TPD was evaporated at a deposition rate of 0.1 nm/sec. to a thickness of 20 nm to form a hole transporting layer.

With the vacuum kept, tris(8-quinolinolato) aluminum (Alq3), and rubrene were evaporated at an overall deposition rate of 0.2 nm/sec. to a thickness of 40 nm, forming a light emitting layer. The layer was doped with 5 vol% of rubrene.

With the vacuum further kept, the assembly was transferred to a sputtering apparatus. Using a target which was prepared by mixing lithium oxide (Li₂O) and magnesium oxide as raw materials so as to give the composition of Sample Nos. 1 to 5 in Table 1, below, an inorganic insulative electron injecting and transporting layer was deposited to a thickness of 0.8 nm. The depositing conditions employed herein included a substrate temperature of 25°C, sputtering gas of Ar, a deposition rate of 1 nm/min, an operating pressure of 0.5 Pa, and an input power of 5 W/cm². Specifically, the sputtering gas of 100% Ar was initially fed at 100 SCCM until the inorganic insulative electron injecting and transporting layer was deposited to a thickness of 0.4 nm. The sputtering gas of Ar/O₂ = 1/1 was subsequently fed at 100 SCCM until the inorganic insulative electron injecting and transporting layer was deposited to a thickness of 0.4 nm.

With the vacuum further kept, Al was evaporated to a thickness of 200 nm to form a negative electrode.

Final sealing of a glass shield completed samples of the organic EL device. As a comparative sample, an organic electroluminescent device was prepared by repeating the procedure as described above except that instead of forming the inorganic insulative electron injecting and transporting layer, tris(8-quinolinolato) aluminum (Alq3) was evaporated at a deposition rate of 0.2 nm/sec. to a thickness of 30 nm, forming an electron injecting and transporting layer, and with the vacuum kept, AlMg (weight ratio, 10:1) was evaporated to a thickness of 200 nm at a deposition rate of 0.2 nm/sec. to form an electron injecting electrode.

An accelerated test was carried out on the organic EL devices by driving the devices at a constant current density of 100 mA/cm² to evaluate emission luminance and life properties. Sample 2 which exhibited a luminance substantially equivalent to the Comparative Sample whose electron injecting and transporting layer had been prepared by using a conventional organic material was used for the standard, and percentage of luminance alteration in relation to Sample 2 was evaluated. The results are shown in Table 2. In the case of Sample 5 prepared by using Li₂O in excess of 98 mol% and MgO below 2 mol%, sintering ability of the target was insufficient and the target could not be produced.

In addition, Sample 2 of the present invention exhibited a luminance half-life of over 200 hours while the luminance half-life of the organic Comparative Sample was below 100 hours.

**Table 1**

| Sample No. | Li₂O (mol%) | MgO (mol%) | Alteration in luminance (%) |
|---|---|---|---|
| 1* | 70 | 30 | -20 |
| 2 | 80 | 20 | 0 |
| 3 | 90 | 10 | 20 |
| 4 | 95 | 5 | 30 |
| 5* | >98 | <2 | Target was not sintered |

| | | | |
|---|---|---|---|
| *) Comparative Sample | | | |

### BENEFITS OF THE INVENTION

As described above, there is realized according to the present invention an organic EL device which has a performance equivalent or superior to the conventional device having a hole injecting and transporting layer and an electron injecting and transporting layer comprising an organic substance, and which has long life and high weatherability, stability, efficiency, as well as low price.

The organic EL device produced can be readily produced even when the light emitting layer comprises two or more layers, and the film interface is provided with stable physical properties.

## Claims

1. An organic electroluminescent device comprising a substrate, a hole injecting electrode and an electron injecting electrode formed on the substrate, and a light emitting layer containing an organic substance formed between the electrodes; wherein
an inorganic insulative electron injecting and transporting layer is formed between the light emitting layer and the electron injecting electrode;
said inorganic insulative electron injecting and transporting layer contains lithium oxide as its main component and magnesium oxide as its stabilizer; and
said lithium oxide calculated on the bases of Li₂O comprises 80 mol% or more of the entire components.

2. An organic electroluminescent device according to claim 1 wherein said inorganic insulative electron injecting and transporting layer has a film thickness of 0.1 to 2 nm.
